# EUROPEAN PATENT APPLICATION

(11) **EP 4 685 843 A1**
(43) Date of publication of application: **28.01.2026**
(21) Application number: 24191199.9
(22) Date of filing: 26.07.2024
(51) Int. Cl.: H01L 21/67, H01L 21/687

(54) **SYNCHRONIZING PIN LIFTING DEVICES**

(71) Applicant: VAT Holding AG, 9469 Haag (CH)
(72) Inventor: ABDELAZIZ, Karim, 8005 Zürich (CH); GRASSO, Emanuele, 9466 Sennwald (CH)
(74) Representative: Kaminski Harmann

(57) **Abstract**

The invention relates to a pin lifting system (1), comprising at least a first pin lifting device (10), wherein the first pin lifting device (10) comprises a first pneumatic actuator (11) with a first pneumatic cylinder (12) and a first moving member (13) movably arranged inside of the first pneumatic cylinder (12). The system comprises a first control valve (21) connected to the first pneumatic actuator (11) and to a first fluid supply and configured to control pressurizing of and/or fluid flow out of or into the first pneumatic actuator (11) to provide movement of the first moving member (13), a first fluid sensor (22) arranged and configured to measure pressurization of and/or fluid flow out of or into the first pneumatic actuator (11), and a controlling unit (30) configured to control the first control valve (21) by applying a first controlling signal and to receive a measurement signal of the first fluid sensor (22). The controlling unit (30) is configured to adjust a movement of the first moving member (13) by providing a reference moving information, the reference moving information representing at least a reference duration of moving a moving member of a pin lifting device from a starting position to an end position, providing moving the first moving member (13) from a first starting position to a first end position by applying the first controlling signal to the first control valve (21), determining a first moving information regarding the movement of the first moving member (13) from the first starting position to the first end position, comparing the first moving information and the reference moving information and deriving a first moving deviation, and adjusting the first controlling signal based on the first moving deviation.

## Description

### FIELD OF INVENTION

The invention relates to a pin lifting system and controller to provide improved driving performance of a pin lifting device for operation in vacuum applications.

### BACKGROUND OF THE INVENTION

Vacuum applications are typically performed in vacuum chamber systems. These applications are performed e.g. in the area of IC, semiconductor or substrate fabrication which must take place in a protected atmosphere as far as possible without the presence of contaminating particles.

The vacuum chamber systems comprise in particular at least one evacuatable vacuum chamber which is provided for receiving semiconductor elements or substrates to be processed or produced and which has at least one vacuum chamber opening, through which the semiconductor elements or other substrates can be guided into and out of the vacuum chamber. For example, in a production plant for semiconductor wafers or liquid crystal substrates, the highly sensitive semiconductor or liquid crystal elements pass sequentially through several process vacuum chambers in which the parts located within the process vacuum chambers are each processed by means of a processing device.

The process chambers often have at least one transfer valve whose cross-section is adapted to the substrate and the robot and through which the substrate can be introduced into the vacuum chamber and, if necessary, removed after the intended processing. Alternatively, a second transfer valve may be provided through which the processed substrate is removed from the chamber.

Moreover, the processing system may comprise one or more peripheral units which are used in particular for controlling or regulating the flow of fluid into and/or out of the vacuum chamber. The peripheral units may be provided by a regulation valve which is located between the vacuum chamber and a vacuum pump or another vacuum chamber or by a gas inlet valve, e.g. a mass-flow controller, which is arranged upstream to provide a particular type and amount of a fluid in the vacuum chamber.

A substrate to be processed, e.g. a wafer, is guided, for example, by a suitably designed and controlled robot arm, which can be guided through the opening in the process chamber provided by the transfer valve. The process chamber is then loaded by holding the substrate with the robot arm, introducing the substrate into the process chamber and depositing the substrate in the chamber in a defined manner. The process chamber is emptied accordingly.

For the handling of the substrate and for the exact positioning of the substrate in the chamber, a relatively high accuracy and mobility of the substrate must be ensured. For this purpose, pin lifting systems (also: pin-lifter) are used which provide a plurality of support points for the substrate and thus a load distribution (due to the dead weight of the substrate) over the entire substrate. The pins can be lowered after depositing the substrate and are then present separated from it, i.e. there is no contact between the pins and the substrate. By that, the substrate can be lifted and deposited on a support structure, like a chuck. After removing the robot arm and closing (and introducing process fluid or evacuating) the chamber, the processing step can be performed.

After processing of the substrate, the substrate has to be raised again. Here, a low force effecting the substrate is particularly important, as the substrate can adhere to the carrier, for example. If the substrate is pushed away from the carrier too quickly, the substrate may break, as the adhesive forces cannot be overcome or resolved at least at certain contact points. In addition, even if contact is established between the support pins and the substrate, any impact with the substrate can lead to undesired stress (or breakage).

At the same time, in addition to the gentlest possible and careful treatment of the substrates to be processed, the shortest possible processing time should also be made possible. This means that the substrate should be brought into the defined conditions - loading and unloading position and processing position - in the chamber as quickly as possible. Pin lifters with pneumatic actuators are therefore preferred.

To avoid unwanted shocks during the processing of semiconductor wafers, for example, US 6,481,723 B1 recommends the use of a special stop device instead of hard motion stops in a pin lifter. Any hard stops should be replaced here by a combination of a softer designed stop part and a hard stop, wherein the contact with the soft stop part is first made for the limitation of movement and then the hard stop is brought into contact with the soft stop part and damped accordingly.

US 6,646,857 B2 proposes a regulation of the lifting movement by means of a recorded occurring force. The lifting pins can be moved as a function of the force signal received so that the lifting force at the lifting pins is always applied to the wafer in a controlled and dosed manner.

Moreover, with view to handling a substrate, it is further important to provide homogeneous movement of the lift pins to provide contact of all pins with the substrate at the same where possible. Further, the pins should be moved with identical speed and accelerations. Both these requirements provide advantageous distribution of touching force over the entire substate as well as horizontal alignment and transportation of the substrate.

However, pneumatic pin lifting devices used for wafer lifting applications are build similar up certain tolerances (techno-logical deviations). Differences in tolerances can occur in various aspects such as spring stiffness, different friction coefficients, mechanical dimensions/parameters or at a proportional valve level to provide particular pressurization of a lifter.

During a typical open-loop operation of a pin lifter, no controller is present to account for discrepancies. A simple pressure/voltage signal is preferably applied to the lifter system under the assumption that all pin-lifters will behave identically and ideally. However, due to the presence of technological discrepancies between each pin lifting device as mentioned, this can result in a non-identical response between each pin lifting device during simultaneous operation when using an identical input voltage or pressure. This can cause position and speed deviations during a motion profile, risking pin-lifter misalignment and subsequently wafer misalignment or breakage.

### OBJECT OF THE INVENTION

It is therefore the object of the present invention to provide an improved pneumatic pin lifting system which reduces or avoids the above disadvantages.

In particular, it is an object of the invention to provide an improved pneumatic actuating system which enables reliable movement of all pin lifting devices arranged.

These objects are solved by implementing the characteristic features of the independent claims. Features which further develop the invention in an alternative or advantageous way can be found in the dependent claims.

### SUMMARY OF THE INVENTION

The approach according to the invention proposes to remedy above issue by an open-loop adjusting or training stage, where e.g. the time of motion of a moving member or a mount of a pin lifting device between distinct known positions is measured (such as between a starting position to an end position, e.g. the full-stroke hard-stop or the wafer contact position) for the pin lifting device or for a plurality of pin-lifting devices given an identical input signal (e.g. input pressure or controlling voltage).

The differences in timing between the motion profiles of the pin lifting devices and a reference profile can then be determined. The reference profile can be provided based on a motion profile of any of the pin lifting devices or can be provided by a (virtual) predetermined reference profile.

The controlling input (controlling signal) can then be adjusted and scaled accordingly for each pin lifting device, i.e. for each of the related control valve, such as to match the reference motion profile, in particular in timing and/or temporal position.

This provides reduction of undesirable effects of intra-pin-lifter technological differences and improves synchronous operation positioning.

The invention relates to a pin lifting system, which comprises at least a first pin lifting device configured for moving and positioning a substrate to be processed in a process atmosphere region which is providable by a vacuum process chamber. The pin lifting device can comprise a lift pin to touch, lift and lower the substrate (e.g. a wafer).

The first pin lifting device comprises a first pneumatic actuator with a first pneumatic cylinder and a first moving member movably arranged inside of the first pneumatic cylinder and which first moving member is configured to be connected with a lift pin and is movable along a first movement axis. In particular, the first moving member is movable from a lowered normal position into an elevated lifting position, and back again. A lift pin, which respectively can be connected with the moving member is moveable accordingly, when connected.

The pin lifting system comprises a first control valve connected to the first pneumatic actuator and to a first fluid supply and configured to control pressurizing of and/or fluid flow out of or into the first pneumatic actuator to provide movement of the first moving member (in an extending direction). In particular, the control valve can be configured to control and provide defined pressure or pressure changes in the actuator, in particular in the pneumatic cylinder of the actuator or in at least one chamber of the pneumatic cylinder. Alternatively or additionally, the control valve can be configured to control and provide defined fluid flow or flow rates or changes thereof in the pneumatic actuator.

The system further comprises a first fluid sensor arranged and configured to measure pressurization of and/or fluid flow out of or into the first pneumatic actuator. Hence, the fluid sensor can be embodied to measure pressure. Alternatively or additionally, the fluid sensor can be configured to measure a flow or flowrate.

A controlling unit is provided and configured to control the first control valve by applying a first controlling signal and to receive a measurement signal of the first fluid sensor.

The controlling unit is configured to adjust a movement of the first moving member by providing a reference moving information, the reference moving information representing at least a reference duration of moving a moving member of a (e.g. typical or general) pin lifting device from a starting position to an end position.

The reference moving information can be non-related to a specific or individual pin lifting device but may be a more general information about moving pin lifters or a type of such pin lifters. The reference moving information can be related to a particular processing cycle, e.g. to how to control a pin lifting device according to a particular process.

Moving the first moving member of the first pin lifting device from a first starting position to a first end position is provided by applying the first controlling signal to the first control valve. The controlling signal applied can be a standard controlling signal, not yet adjusted to a particular lifting device.

A first moving information regarding the movement of the first moving member from the first starting position to the first end position is determined.

The first moving information and the reference moving information are compared and (based thereon) a first moving deviation is derived.

The first controlling signal is adjusted based on the first moving deviation.

In particular, as a result, an adjusted controlling signal can be determined which can be applied to the first pin lifting device to provide a movement of the first moving member which is adjusted to a reference movement.

In one embodiment, the first moving information can comprise at least one of the following:
- a first moving time for the first moving member, wherein the first moving time corresponds to a duration of moving the first moving member from the first starting position to the first end position due to applying the first controlling signal,
- a first pressure-time profile providing an information related to a change of pressure in the first pneumatic actuator, in particular in a chamber of the first pneumatic cylinder, for at least the time of moving the first moving member from the first starting position to the first end position,
- a first flow-time profile providing an information related to a change of fluid flow out of or into the first pneumatic actuator for at least the time of moving the first moving member from the first starting position to the first end position, and
- a first position-time profile providing an information related to a change of a position of the first moving member along the first movement axis for at least the time of moving the first moving member from the first starting position to the first end position.

The reference moving information can comprise at least one of the following:
- a reference moving time for a moving member of a pin lifting device, wherein the reference moving time corresponds to a duration of moving the moving member from the starting position to the end position due to applying a controlling signal,
- a reference pressure-time profile providing an information related to a change of pressure in a pneumatic actuator for at least the time of moving the moving member from the starting position to the end position,
- a reference flow-time profile providing an information related to a change of fluid flow out of or into a pneumatic actuator for at least the time of moving the first moving member from the starting position to the end position, and
- a reference position-time profile providing an information related to a change of a position of the moving member along the movement axis for at least the time of moving the moving member from the starting position to the end position.

In one embodiment, the first moving deviation can comprise at least one of the following:
- a time deviation,
- a deviation concerning pressure-time profiles,
- a deviation concerning flow-time profiles and
- a deviation concerning position-time profile.

Such deviation can provide a suitable basis for how to adjust the controlling signal. As for example, in case of little differences of pressure-time profiles, e.g. of a reference profile and a measured profile, respectively minor changes in the controlling signal can be sufficient.

In one embodiment, the first end position can be provided by at least one of
- a first hard stop of the first pin lifting device,
- a position of contacting the substrate with the lift pin, or
- a full stroke of the first pin lifting device.

Such first hard stop can be arranged inside of the pneumatic cylinder to limit the movement range of the moving member in at least one direction, in particular in an extension direction.

According to one embodiment, the controlling unit can be configured to detect reaching of the first end position by the first moving member by measuring pressurization of the first pneumatic actuator and/or fluid flow into the pneumatic actuator by the first fluid sensor and monitoring a change of the pressure in the first pneumatic actuator and/or a change of the fluid flow into the first pneumatic actuator and/or of the volume of the first chamber of the actuator.

In particular, the first controlling signal is additionally considered or processed to determine reaching of the first end position by the first moving member.

In one embodiment, the first pin lifting device can comprise a position sensor configured and arranged to acquire position data concerning a position of the first moving member and/or of a mount of the pin lifting device along the first movement axis, in particular to acquire position data concerning the first end position. The controlling unit can be configured to receive the position data to detect reaching of the first end position by the first moving member.

In one embodiment, the first control valve can provide a defined fluid flow into the first pneumatic actuator or a defined fluid pressure in the first pneumatic actuator as a function of the applied controlling signal, wherein the controlling signal provides a controlling voltage or controlling current. Further, the adjusting of the first controlling signal can comprise adjusting the controlling voltage or the controlling current to provide movement of the first moving member according to the reference moving information.

In particular, if a duration of moving the first moving member from the first starting position to the first end position is smaller than the reference duration, adjusting of the first controlling signal can comprise reducing the fluid flow into the first pneumatic actuator due to applying the first controlling signal, in particular reducing the controlling voltage and/or current.

In particular, if a duration of moving the first moving member from the first starting position to the first end position is greater than the reference duration, adjusting of the first controlling signal can comprise increasing the fluid flow into the first pneumatic actuator due to applying the first controlling signal, in particular increasing the controlling voltage and/or current.

In one embodiment, the pin lifting system can comprise a second pin lifting device, which comprises a second pneumatic actuator with a second pneumatic cylinder and a second moving member movably arranged inside of the second pneumatic cylinder and which second moving member is configured to be connected with a lift pin and is movable along a second movement axis, in particular from a lowered normal position into an elevated lifting position, and back again.

The pin lifting system can further comprise a second control valve connected to the second pneumatic actuator and to a second fluid supply and configured to control pressurizing of and/or fluid flow out of or into the second pneumatic actuator to provide movement of the second moving member in an extending direction.

A second fluid sensor can be arranged and configured to measure pressurization of and/or fluid flow out of or into the second pneumatic actuator.

The controlling unit can respectively be configured to adjust a movement of the second moving member by providing moving the second moving member from a second starting position to a second end position by applying a second controlling signal to the second control valve, determining a second moving information regarding the movement of the second moving member from the second starting position to the second end position, comparing the second moving information and the reference moving information and deriving a second moving deviation, and adjusting the second controlling signal based on the second moving deviation.

In one alternative embodiment the second control valve can be embodied by the first control, valve, e.g. the first and the second pin lifting device are controlled by one common valve.

According to one embodiment, the controlling unit can be configured to provide the reference moving information based on the first moving information and/or the second moving information, in particular based on processing or averaging the first and the second moving information. In particular, the first moving information can be used as the reference moving information.

This enables to adjust one pin lifting device based on characteristics of another such device and/or based on an (isolated) reference.

In one embodiment, the controlling unit can be configured to synchronize the movements of the first and the second moving member by comparing the first moving information and the second moving information, deriving a synchronous moving deviation, and adjusting the first and/or the second controlling signal based on the synchronous moving deviation to provide reaching of the first end position and the second end position with identical moving durations for the first and the second moving member.

In one embodiment, the controlling unit can be configured to
- equally pressurize the first and the second pneumatic actuator and/or to provide equal fluid flow to the first and the second pneumatic actuator and by that moving the first and the second moving member in the extending direction, and/or
- apply identical controlling signals to the first and the second control valve to provide moving of the first and the second moving member to the first and the second end position, and/or
- provide the adjusted first controlling signal and/or the adjusted second controlling signal to open-loop-control the first and/or the second control valve.

According to an embodiment, the first fluid supply and the second fluid supply provide pre-defined fluid pressures or the second fluid supply is provided by the first fluid supply. As for example, the control valves of the system can be supplied by one common fluid supply.

In case of at least two fluid supplies further fluid (e.g. flow) sensors can be arranged between the respective fluid supply and the supplied control valve to measure the inlet flow and/or pressure into the control valve. This can enable to provide (and know about) particular flow rates through the control valve.

In one embodiment, the first pneumatic actuator comprises a first chamber and a second chamber in the pneumatic cylinder defined by providing separation of an inner volume of the pneumatic cylinder by the first moving member. A stem can be connected to the moving member, extending outside the pneumatic cylinder and being connected to a first mount. The first mount can be configured to hold and provide the lift pin. A first fluid passage can provide passage of a fluid into and out of the first chamber.

The first control valve can be is connected to the first fluid passage and can be configured to provide controlling of fluid flow into the first chamber, and the first fluid sensor can be arranged and configured to measure the pressure in and/or fluid flow out of or into the first chamber.

In particular, the first pneumatic actuator can comprise a second fluid passage providing passage of a fluid into and out of the second chamber and a third control valve connected to the second fluid passage and configured to provide controlling of fluid flow into the second chamber.

In particular, the first pneumatic actuator can comprise a first restoring element connected to the moving member and applying a first restoring force to the moving member acting in a direction opposite the extending direction.

The invention also relates to a controlling unit for a pin lifting system. The pin lifting system comprises at least a first pin lifting device configured for moving and positioning a substrate to be processed in a process atmosphere region which is providable by a vacuum process chamber.

The at least first pin lifting device comprises a first pneumatic actuator with a first pneumatic cylinder and a first moving member movably arranged inside of the first pneumatic cylinder and which first moving member is configured to be connected with a lift pin and is movable along a first movement axis, in particular from a lowered normal position into an elevated lifting position, and back again.

The pin lifting system comprises a first control valve connected to the first pneumatic actuator and to a first fluid supply and configured to control pressurizing of and/or fluid flow out of or into the first pneumatic actuator to provide movement of the first moving member in an extending direction. The pin lifting system also comprises a first fluid sensor arranged and configured to measure pressurization of and/or fluid flow out of or into the first pneumatic actuator,

The controlling unit is configured to provide a reference moving information, the reference moving information representing at least a reference duration of moving a moving member of a pin lifting device from a starting position to an end position, provide moving the first moving member from a first starting position to a first end position by applying a first controlling signal to the first control valve, determine a first moving information regarding the movement of the first moving member from the first starting position to the first end position, compare the first moving information and the reference moving information and deriving a first moving deviation, and adjust the first controlling signal based on the first moving deviation.

According to embodiments, the controlling unit can be configured according to a controlling unit described herein.

### BRIEF DESCRIPTION OF THE DRAWINGS

The system according to the invention and the method according to the invention are described in detail hereinafter merely as an example with reference to specific exemplary embodiments shown schematically in the drawings, wherein further advantages of the invention are also discussed. In detail in the figures:
Figure 1 shows an embodiment of a pin lifting system according to the invention.
Figure 2 shows another embodiment of a pin lifting system according to the invention.
Figures 3a and 3b show a controlling behavior of two pin lifting devices before and after adjusting their controlling signals according to the invention.
Figure 4 shows another embodiment of a pin lifting system according to the invention.

### DETAILED DESCRIPTION OF THE DRAWINGS

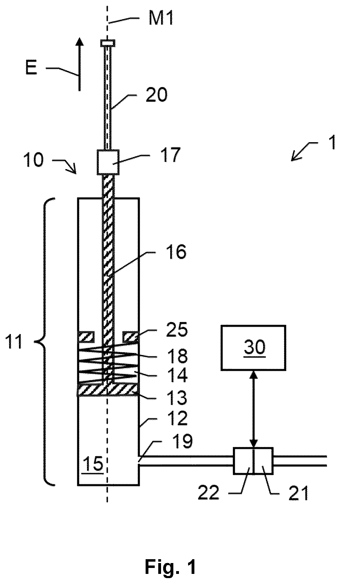

Figure 1 shows schematically an embodiment of a pin lifting system 1 according to the invention.

The pin lifting system 1 comprises a pin lifting device 10 with a pneumatic actuator 11. The pneumatic actuator 11 comprises a cylinder 12 separated into two chambers 14,15 by a moving member 13. The moving member 13 may preferably be a piston. A stem 16 is connected to the moving member 13 and extends outside the inner volume of the cylinder 12. The stem 16 is configured to provide actuation of a connected first mount 17 to be moved. A lift pin 20 is attached to the mount 17. Hence, a load is applied to the moving member 13 by the stem 16, i.e. by the weight of the stem 16, and/or by an additional element which interacts with the stem 16, like the lift pin 20 or a lifted substrate.

It is to be understood that at least the mount 17 is an optional element. A connection between the moving member 13 and the lift pin 20 may alternatively be provided by a direct connection, in particular the moving member 13 and the lift pin 20 are built as one single part.

The pneumatic actuator 11 further comprises a first fluid passage 19. The first fluid passage 19 enables fluid flow into and out of the first chamber 15.

Further, the pneumatic actuator 11 comprises a restoring element 18, in particular a spring. The restoring element 18 is connected to the moving member 13 and applies a restoring force to the moving member 13. In the shown embodiment, the restoring element 18 is arranged inside of the second chamber 14.

The system 1 also comprises a first control valve 21 connected to the first fluid passage 19 and to a fluid supply and configured to provide controlling of fluid flow into the first chamber 15. The fluid supply may be provided by a high-pressure fluid source, e.g. a reservoir of compressed air. The first control valve may be a proportional control valve capable of providing a defined fluid flow as a function of a respectively applied controlling signal.

The control valve 21 provides controlled varying of a flow and/or pressure into the chamber 15.

A first fluid sensor 22 is arranged and configured to measure the pressure in the first chamber 15, i.e. at one side of the pneumatic cylinder. The first fluid sensor is embodied as a pressure sensor 22 and provides pressure feedback from the first chamber 15, i.e. a pressure affecting the moving member 13.

In an alternative embodiment, the first fluid sensor 22 can be a flow meter to measure fluid flow out of the control valve 21 and/or into the chamber 15.

In an alternative embodiment, the system may comprise a further flow meter to additionally measure fluid flow from the fluid supply to the control valve. By that, the flow into the control valve 21 and out of the control valve 21 can be determined.

In an alternative embodiment, the first fluid sensor may be a flow rate sensor.

As shown, the pressure sensor can be arranged in the course of a supply line for the respective chamber 15. The pressure sensor 22 may be arranged together with the respective control valve 21 (as shown) or may be located separated from the valve 22 (not shown).

The pin lifting system 1 comprises a controlling unit 30. The controlling unit 30 is configured to control a movement of the moving member 13 by applying a particular pressure in the chambers 15. The pressures in the chambers 15 can be varied by controlling the control valve 21 to increase or decrease the pressure in the chamber 15.

The controlling unit 30 is connected with the pressure sensor 22 to receive pressure information related to the chamber 15.

In one embodiment, the controlling unit 30 can integrally be built with the pressure sensor 22.

The controlling unit 30 is configured to derive and generate respective controlling signals for the first control valve 21. The controlling signals can provide to set and vary a pressure inside of the first chamber 15 and, by that, to set and vary a force counteracting the restoring force of the restoring element 18.

According to the invention, the movement of the pin lifter 10, i.e. of the moving member 13 and the mount 17, due to applying the controlling signal can be adjusted by running a defined learning or adjusting cycle. This can in particular be advantageous since the pin lifter is typically driven in an open-loop manner, i.e. there is no feedback information available to control or regulate the movement of the moving member 13 when varying the pressure in the first chamber 15.

The movement of the first moving member 13 is adjusted by respectively adjusting the controlling signal which provides defined pressurization of the first chamber 15. For that, a reference moving information is provided. The reference moving information represents at least a reference duration of moving a moving member of a pin lifting device from a starting position to an end position. Such reference moving information may be generated by an operator of the system 1 or may be derived based on performing such adjusting cycle in advance, e.g. by means of a further pin lifting device.

The reference moving information can comprise a reference moving time for a moving member of a pin lifting device, wherein the reference moving time corresponds to a duration of moving the moving member from the starting position to the end position due to applying a controlling signal. Further, the reference moving information can comprise a reference position-time profile providing an information related to a change of a position of the moving member along the movement axis for at least the time of moving the moving member from the starting position to the end position.

In particular, the reference moving information is not assigned or connected to any controlling or structural design of the pin lifter 10 the movement of which should be adjusted. However, the reference moving information should provide a target or nominal state of motion according to which the pin lifter 10 should be driven.

To provide adjusting the movement of the first moving member 13 or the first mount 17, the moving member is preferably provided in a first starting position. The first starting position can correspond to a "zero" position, i.e. a position the mount 17 and the moving member 13 are provided retraced, e.g. in a lowest possible position. Alternatively, the moving member 13 is provided in an alternative position which is determined respectively.

The first starting position of the first moving member 13 correlates with a starting position referred to by the reference moving information.

The controlling unit 30 is configured to provide moving of the first moving member 13 from the first starting position to a first end position by applying a first controlling signal to the first control valve. The first end position can correspond to a full-stroke of the moving member, i.e. a position which is provided when the moving member 13 reaches a hard stop 25 provided inside the cylinder 12.

Alternatively, the first end position can be provided by a position of contacting the substrate with the lift pin 20, or any other position which can be determined respectively.

The controlling unit 30 is further configured to determine a first moving information regarding the movement of the first moving member 13 from the first starting position to the first end position. The first moving information can comprise a first moving time for the first moving member 13, wherein the first moving time corresponds to a duration of moving the first moving member 13 from the first starting position to the first end position due to applying the first controlling signal. Further the first moving information can comprise a first position-time profile providing an information related to a change of a position of the first moving member 13 along the first movement axis for at least the time of moving the first moving member 13 from the first starting position to the first end position.

The controlling unit further provides comparing the first moving information and the reference moving information and deriving a first moving deviation. Since knowing the controlling signal which was applied to drive the moving member 13 such input can then be adjusted and scaled accordingly for the first pin lifting device 10 such as to match the reference moving information (e.g. reference motion profile) in timing and temporal position.

The first moving deviation can comprise a time deviation concerning the duration to reach the end position or a deviation concerning a position-time profile. The first controlling signal is adjusted accordingly based on the first moving deviation.

For adjusting the controlling signal, a pre-known response of the moving member as a function of an applied controlling signal, in particular of an applied controlling voltage, is considered or processed. An outlet flow of the control valve 21 can be varied by varying the applied controlling voltage. In other words, a change of a motion behavior of the moving member 13 by a particular change of the controlling signal can at least be estimated or is known.

In one embodiment of the present invention, the adjusting cycle is performed several times and the motion characteristic of the pin lifting device 10 is iteratively adjusted and approached to a reference characteristic.

Reaching the first end position by the moving member 13 can be detect by the controlling unit 30 by measuring pressurization of the first pneumatic actuator by the first pressure sensor 22 and monitoring a change of the pressure in the first pneumatic actuator. As for example, when contacting the hard stop 25 with the moving member 13 the course of a time-pressure curve can preferably deviate from a homogenous development and provides a pressure peak to be detected.

This means that the moment in time when the mount and/or the moving member reaches the end position can be detected by means of the pressure sensor 22 and the controlling unit 30.

In one embodiment, the pin lifting system 1 can comprise temperature sensor to measure the ambient temperature and/or the temperature of the fluid used to pressurize the first actuator 11. Since the temperature or a change of temperature of the fluid can have significant influence on a resulting pressure in the chamber 15 when providing a particular amount of fluid, an information about an actual temperature can additionally be processed to adjust the controlling signal.

In one embodiment, an information regarding a pressure of a supply fluid which is provided to the control valve 21 can be available. Since the supply pressure can directly influence the resulting chamber pressure, this information can also be considered for adjusting the controlling signal.

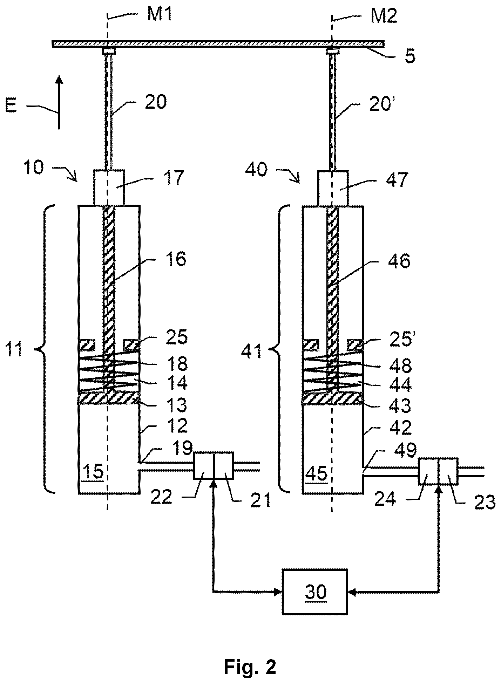

Figure 2 shows an embodiment of a pin lifting system 1 according to the invention. In contrast to the embodiment of figure 1, here, a second pin lifting device 40, second control valve 23 and a second fluid sensor 24 are arranged. Both pin lifting devices 10 and 40 are provided to handle a substrate 5, e.g. a semiconductor wafer, in a vacuum atmosphere. Hence, the lift pins 20 and 20' can be provided in a vacuum chamber while the respective pneumatic actuators 11 and 41 can be arranged outside of the vacuum chamber.

As mentioned above, the substrate is required to be handled with high precision, meaning the substrate should be lifted and lowered such that it remains horizontally aligned and not misalignment occurs. For that, the movement of the pin lifting devices 10 and 40, i.e. the movement of their lift pins 20 and 20' has to be synchronous. Due to structurally given deviations of the pin lifting devices 10 and 40 (by natural tolerances of parts or different spring constants) such movement of the lift pins 20 and 20' when applying identical pressure to each pneumatic actuator 11 and 41 typically is not identical as well.

Hence, an adjustment of the moving behavior of at least one of the pin lifting devices 10 and 40 can be performed according to the invention.

As can be seen the second pin lifting device 40 comprises a second pneumatic actuator 41 which comprises a second cylinder 42, a second moving member 43, respective third and fourth chambers 44 and 45 inside of the cylinder 42, a second stem 46 and a second restoring element 48. Further, the second pin lifting device 40 comprises a second mount 47, a second hard stop 25' and a second fluid passage 49. The second moving member 43 and/or the second mount 48 is moveable long a second moving axis M2.

The second control valve 23 and the second fluid sensor 24 are connected to the controlling unit 30.

The controlling unit 30 is configured to provide adjustment of the motion profile of at least one of the two pin lifting devices 10 and 40 to provide identical or synchronized motion profiles for both lifters 10,40.

For that, an adjusting cycle as mentioned above is performed with both pin lifting devices 10 and 40.

Moving of the first moving member 13 and of the second moving member 43 from respective (first and second) starting positions to respective (first and second) end positions by applying a respective (first and second) controlling signals to the respective (first and second) control valves 21, 23 is provided (controlled) by the controlling unit 30.

Respective first and second moving information is derived regarding the movement of the first and second moving members 13,43 from the starting positions to the end positions.

In case the motion profiles of the two pin lifting devices 10 and 40 are to be synchronized relative to each other, the first and second moving information are compared to each other and a moving deviation is derived based on the comparison. One of the determined motion profiles (first and second moving information) can here be considered to be the reference motion profile (reference moving information).

Such moving deviation can further be used to determine a difference of duration when the moving members 13,43 had reached the end positions. Based thereon, the controlling signal of one of the control valves 21 or 23 can be adjusted to either accelerate or decelerate movement of the respective moving member when the adjusted controlling signal is applied.

Knowing the chamber 15,45 dimensions, in particular the effective surfaces of the moving members 13,43, and/or the characteristics of the restoring elements 18,48, in particular the spring constants, a change of the motion profile of the respective moving member 13,43 as a function of how pressurizing the respective actuator 11,41 can be predicted or estimated. Hence, the adjustment of the controlling signal can be provided respectively.

In case the motion profiles of the two pin lifting devices 10 and 40 are to be synchronized with a (further) reference motion profile (reference moving information), the first and second moving information are both compared with the reference moving information and respective first and second moving deviations are derived. The controlling signals for the first and second control valve 21,23 are both adjusted to match with the reference motion profile.

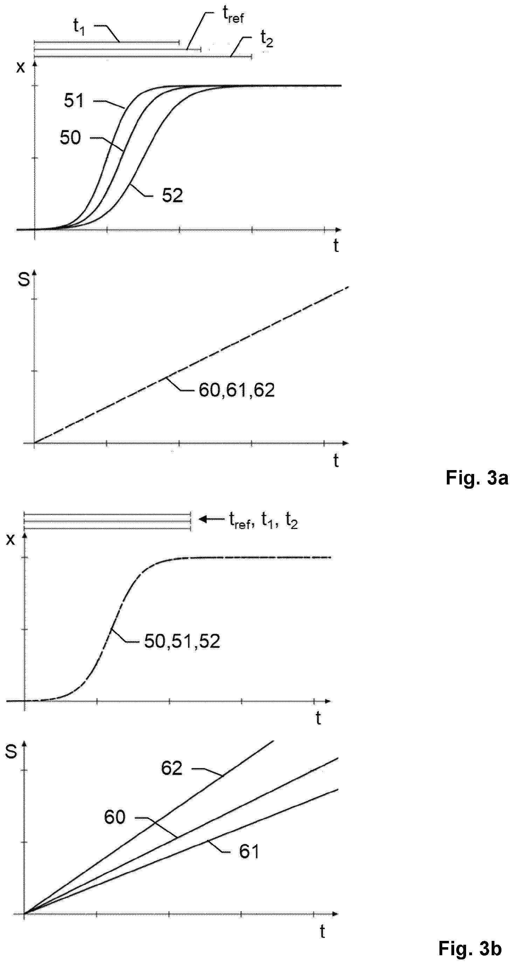

Figures 3a and 3b show motion behaviors of two pin lifting devices of a pin lifting system according to the invention before and after adjusting the controlling signals used to control their control valves or before and after adjusting the development of pressurizations of their actuators.

Figure 3a shows a first motion profile 51 (position x over time t) of a first pin lifting device when moving the first moving member from the first starting position to the first end position due to applying a first controlling signal 61 (signal S over time t), which first controlling signal 61 corresponds to a standard or calibration controlling signal 60. Further, a second motion profile 52 of a second pin lifting device is shown when moving the second moving member from the second starting position to the second end position due to applying a second controlling signal 62, which second controlling signal 61 also corresponds to the standard or calibration controlling signal 60.

In addition, a reference motion profile 50 (reference moving information) is shown which is desired to be realized by the first and the second pin lifting device. The standard or calibration controlling signal 60 is assigned to the reference motion profile 50.

Based on the first and second motion profiles 51,52 respective moving times t₁ and t₂ are derived which represent respective durations of motions from the starting to the end positions. A reference moving time t_{ref} is know from the reference motion profile 50. Respective deviations in moving times can further be determined by comparing the moving times t₁ and t₂ with the reference moving time t_{ref} .

The controlling signals 61 and 62 can then be adjusted to provide adjusted motion profiles.

Figure 3b shows the result of adjusting the controlling signals 61 and 62. Since the movement of the first pin lifting device was determined to be too fast, i.e. the moving time t₁ is shorter than the reference moving time t_{ref}, the controlling signal 61 is adjusted to be lower, i.e. the controlling voltage or current is reduced which results in less fluid flow through the first control valve. This results in decreased rise of pressure in the chamber of the first pin lifting device and, hence, to slower motion of the first moving member when applying the first controlling signal 61.

Concerning the motion profile 52 of the second pin lifting device the movement was found to be too slow, i.e. the moving time t₂ is longer than the reference moving time t_{ref}. Therefore, the controlling signal 62 is adjusted to be stronger, i.e. the controlling voltage or current is increased which results in more fluid flow through the second control valve. This results in increased rise of pressure in the chamber of the second pin lifting device and, hence, to faster motion of the second moving member when applying the second controlling signal 62.

Finally, the motion profiles 51 and 52 of the first and second pin lifting device correspond with the reference profile 50.

It is to be understood that the approach described herein is not limited to be applied for two pin lifting devices but can be applied for multiple pin lifting devices resulting in synchronous movement of multiple pin lifting devices.

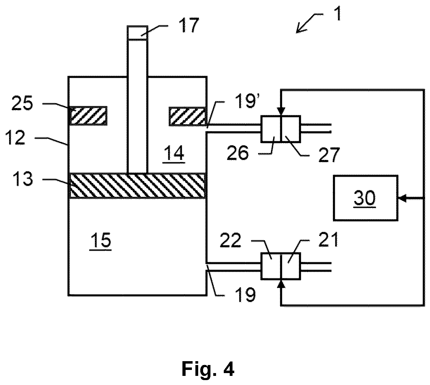

Figure 4 shows an embodiment of a pin lifting system 1 according to the invention. In contrast to the embodiment of figure 1, here, the first pin lifting device does not comprise a restoring element but comprises a further fluid passage 19' for the second chamber 14.

Movement of the moving member 13 can be controlled by applying and varying respective controlling signals by the two control valves 21 and 27. By that a pressure and pressure difference between the two chambers 14 and 15 can respectively be set and varied.

Referring to the adjusting of the motion profile of the pin lifting device the adjusting cycle can be performed as described above. Based on a determined motion deviation, here, the controlling signal of either one of the control valves 21,27 or of both controlling signals can be adjusted to adjust a development of the pressure difference when applying the signals and by that changing the motion profile.

It is understood that the depicted figures only schematically depict possible exemplary embodiments. The various approaches can according to the invention also be combined with one another and with prior art methods and devices for controlling of a pneumatic actuator.

## Claims

1. Pin lifting system (1), comprising
• at least a first pin lifting device (10) configured for moving and positioning a substrate (5) to be processed in a process atmosphere region which is providable by a vacuum process chamber, wherein the first pin lifting device (10) comprises a first pneumatic actuator (11) with a first pneumatic cylinder (12) and a first moving member (13) movably arranged inside of the first pneumatic cylinder (12) and which first moving member (13) is configured to be connected with a lift pin (20) and is movable along a first movement axis (M1),
• a first control valve (21) connected to the first pneumatic actuator (11) and to a first fluid supply and configured to control at least one of pressurizing of the first pneumatic actuator (11) or fluid flow out of or into the first pneumatic actuator (11) to provide movement of the first moving member (13),
• a first fluid sensor (22) arranged and configured to measure at least one of pressurization of the first pneumatic actuator (11) or fluid flow out of or into the first pneumatic actuator (11),
• a controlling unit (30) configured to control the first control valve (21) by applying a first controlling signal and to receive a measurement signal of the first fluid sensor (22),
**characterized in that**
the controlling unit (30) is configured to adjust a movement of the first moving member (13) by
• providing a reference moving information, the reference moving information representing at least a reference duration of moving a moving member of a pin lifting device from a starting position to an end position,
• providing moving the first moving member (13) from a first starting position to a first end position by applying the first controlling signal to the first control valve (21),
• determining a first moving information regarding the movement of the first moving member (13) from the first starting position to the first end position,
• comparing the first moving information and the reference moving information and deriving a first moving deviation, and
• adjusting the first controlling signal based on the first moving deviation.

2. Pin lifting system (1) according to any of the preceding claims, wherein
the first moving information comprises at least one of the following:
• a first moving time for the first moving member (13), wherein the first moving time corresponds to a duration of moving the first moving member (13) from the first starting position to the first end position due to applying the first controlling signal,
• a first pressure-time profile providing an information related to a change of pressure in the first pneumatic actuator (11) for at least the time of moving the first moving member (13) from the first starting position to the first end position,
• a first flow-time profile providing an information related to a change of fluid flow out of or into the first pneumatic actuator (11) for at least the time of moving the first moving member (13) from the first starting position to the first end position, and
• a first position-time profile providing an information related to a change of a position of the first moving member (13) along the first movement axis (M1) for at least the time of moving the first moving member (13) from the first starting position to the first end position,
and the reference moving information comprises at least one of the following:
• a reference moving time for a moving member of a pin lifting device, wherein the reference moving time corresponds to a duration of moving the moving member from the starting position to the end position due to applying a controlling signal,
• a reference pressure-time profile providing an information related to a change of pressure in a pneumatic actuator for at least the time of moving the moving member from the starting position to the end position,
• a reference flow-time profile providing an information related to a change of fluid flow out of or into a pneumatic actuator for at least the time of moving the first moving member from the starting position to the end position, and
• a reference position-time profile providing an information related to a change of a position of the moving member along the movement axis for at least the time of moving the moving member from the starting position to the end position.

3. Pin lifting system (1) according to any of the preceding claims, wherein
the first moving deviation comprises at least one of the following:
• a time deviation,
• a deviation concerning pressure-time profiles,
• a deviation concerning flow-time profiles, and
• a deviation concerning position-time profile.

4. Pin lifting system (1) according to any of the preceding claims, wherein
the first end position is provided by
• a first hard stop (25) of the first pin lifting device (10),
• a position of contacting the substrate (5) with the lift pin (20), or
• a full stroke of the first pin lifting device (10).

5. Pin lifting system (1) according to any of the preceding claims, wherein
the controlling unit is configured to detect reaching of the first end position by the first moving member (13) by
• measuring pressurization of the first pneumatic actuator (11) by the first fluid sensor (22) and
• monitoring a change of the pressure in the first pneumatic actuator (11).

6. Pin lifting system (1) according to any of the preceding claims, wherein
• the first pin lifting device (10) comprises a position sensor configured and arranged to acquire position data concerning a position of the first moving member along the first movement axis, and
• the controlling unit is configured to receive the position data to detect reaching of the first end position by the first moving member.

7. Pin lifting system (1) according to any of the preceding claims, wherein
• the first control valve (21) provides a defined fluid flow into the first pneumatic actuator (11) or a defined fluid pressure in the first pneumatic actuator (11) as a function of the applied controlling signal, wherein the controlling signal provides a controlling voltage or controlling current, and
• adjusting of the first controlling signal comprises adjusting the controlling voltage or the controlling current to provide movement of the first moving member (13) according to the reference moving information.

8. Pin lifting system (1) according to any of the preceding claims, wherein
the pin lifting system (1) comprises
• a second pin lifting device (40), which comprises a second pneumatic actuator (41) with a second pneumatic cylinder (42) and a second moving member (43) movably arranged inside of the second pneumatic cylinder (42) and which second moving member (43) is configured to be connected with a lift pin (20') and is movable along a second movement axis (M2),
• a second control valve (23) connected to the second pneumatic actuator (41) and to a second fluid supply and configured to control at least one of pressurizing of or fluid flow out of or into the second pneumatic actuator (41) to provide movement of the second moving member (43),
• a second fluid sensor (24) arranged and configured to measure at least one of pressurization of or fluid flow out of or into the second pneumatic actuator (41), wherein the controlling unit (30) is configured to adjust a movement of the second moving member (43) by
• providing moving the second moving member (43) from a second starting position to a second end position by applying a second controlling signal to the second control valve (23),
• determining a second moving information regarding the movement of the second moving member (43) from the second starting position to the second end position,
• comparing the second moving information and the reference moving information and deriving a second moving deviation, and
• adjusting the second controlling signal based on the second moving deviation.

9. Pin lifting system (1) according to claim 8, wherein
the controlling unit (30) is configured to provide the reference moving information based on at least one of the first moving information or the second moving information.

10. Pin lifting system (1) according to claim 8 or 9, wherein
the controlling unit (30) is configured to synchronize the movements of the first and the second moving member by
• comparing the first moving information and the second moving information
• deriving a synchronous moving deviation,
• adjusting at least one of the first or the second controlling signal based on the synchronous moving deviation to provide reaching of the first end position and the second end position with identical moving durations for the first and the second moving member.

11. Pin lifting system (1) according to any of the claims 8 to 10, wherein
the controlling unit (30) is configured to provide at least one of the following:
• equally pressurizing the first and the second pneumatic actuator and by that moving the first and the second moving member in the extending direction,
• applying identical controlling signals to the first and the second control valve (21) to provide moving of the first and the second moving member to the first and the second end position, and
• the adjusted first controlling signal or the adjusted second controlling signal to open-loop-control the first or the second control valve.

12. Pin lifting system (1) according to any of the claims 8 to 11, wherein
the first fluid supply and the second fluid supply provide pre-defined fluid pressures or the second fluid supply is provided by the first fluid supply.

13. Pin lifting system (1) according to any of the preceding claims, wherein
• the first pneumatic actuator (11) comprises
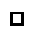 a first chamber (15) and a second chamber (14) in the pneumatic cylinder (12) defined by providing separation of an inner volume of the pneumatic cylinder (12) by the first moving member (13),
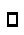 a stem (16) connected to the moving member (13), extending outside the pneumatic cylinder (11) and connected to a first mount (17),
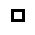 a first fluid passage (19) providing passage of a fluid into and out of the first chamber (15),
• the first control valve (21) is connected to the first fluid passage (19) and is configured to provide controlling at least one of pressurizing of the first chamber (15) or fluid flow out of or into the first chamber (15), and
• the first fluid sensor (22) is arranged and configured to measure at least one of the pressure in the first chamber (15) or the fluid flow out of or into the first chamber (15).

14. Controlling unit for a pin lifting system, the pin lifting system comprises
• at least a first pin lifting device configured for moving and positioning a substrate (5) to be processed in a process atmosphere region which is providable by a vacuum process chamber, the at least first pin lifting device comprises a first pneumatic actuator (11) with a first pneumatic cylinder (12) and a first moving member (13) movably arranged inside of the first pneumatic cylinder (12) and which first moving member (13) is configured to be connected with a lift pin (20) and is movable along a first movement axis (M1),
• a first control valve (21) connected to the first pneumatic actuator and to a first fluid supply and configured to control at least one of pressurizing of the first pneumatic actuator or fluid flow out of or into the first pneumatic actuator to provide movement of the first moving member, and
• a first fluid sensor (22) arranged and configured to measure at least one of pressurization of the first pneumatic actuator or fluid flow out of or into the first pneumatic actuator,
the controlling unit being configured to
• provide a reference moving information, the reference moving information representing at least a reference duration of moving a moving member of a pin lifting device from a starting position to an end position,
• provide moving the first moving member (13) from a first starting position to a first end position by applying a first controlling signal to the first control valve,
• determine a first moving information regarding the movement of the first moving member (13) from the first starting position to the first end position,
• compare the first moving information and the reference moving information and deriving a first moving deviation,
• adjust the first controlling signal based on the first moving deviation.

15. Controlling unit according to claim 14, wherein
the controlling unit is configured according to a controlling unit according to any of the claims 1 to 13.
